# EUROPÄISCHE PATENTSCHRIFT

(11) **EP 1 593 143 B1**
(45) Veröffentlichungstag und Bekanntmachung des Hinweises auf die Patenterteilung: **09.12.2009**
(21) Anmeldenummer: 04710352.8
(22) Anmeldetag: 12.02.2004
(51) Int. Cl.: H01J 37/32, H01J 37/34, G05F 1/66

(54) **LEISTUNGSZUFUHRREGELEINHEIT**
POWER SUPPLY CONTROL UNIT
UNITE DE REGULATION DE L'ALIMENTATION DE PUISSANCE

(30) Priorität: 15.02.2003 DE 10306347
(43) Veröffentlichungstag der Anmeldung: 09.11.2005
(73) Patentinhaber: HÜTTINGER Elektronik GmbH + Co. KG, 79111 Freiburg (DE)
(72) Erfinder: WIEDEMUTH, Peter, 79336 Herbolzheim (DE); TRUSCH, Alfred, 79206 Breisach (DE); MEIER, Dieter, 79206 Breisach (DE); ZÄHRINGER, Gerhard, 79112 Freiburg (DE)
(74) Vertreter: Schiz, Jochen
(86) Internationale Anmeldenummer: PCT/EP2004/001293
(87) Internationale Veröffentlichungsnummer: WO 2004/072754

(56) Entgegenhaltungen:
- EP-A2- 0 534 068
- DE-A1- 4 127 505
- DE-A1- 4 326 100
- DE-A1- 19 605 314
- DE-C1- 4 324 683
- DE-C1- 19 506 515

## Beschreibung

Die Erfindung betrifft ein Verfahren zur Leistungszufuhr der von einer Wechselstromquelle gelieferten Leistung auf zwei Verbraucher und eine Vorrichtung zur Durchführung des Verfahrens.

Bei einem Plasmaprozess sind die als Elektroden ausgebildeten Verbraucher in einer Plasmakammer positioniert. Zur Anregung des Plasmaprozesses werden die Elektroden mit der Wechselspannung der Leistungsversorgung verbunden. Die Elektroden stehen in Kontakt zu sogenannten Targets. Die Targets bestehen aus dem Basismaterial, das beispielsweise zur Beschichtung benötigt wird. In einem solchen Plasmabeschichtungsprozess wird dieses Material von den Targets abgetragen. Die Targets sind in solchen Anordnungen üblicherweise gleichartig, das heißt sie bestehen aus dem gleichen Material, sie besitzen im Wesentlichen die gleiche Größe und den gleichen Aufbau. Daher wird ihnen üblicherweise im Wesentlichen die gleiche Leistung zugeführt. Damit werden die Targets im Plasmaprozess im Wesentlichen gleich schnell abgetragen. Geringfügige Unterschiede können aber nie ausgeschlossen werden. Gewisse Unsymmetrien der Targets können von Anfang an bestehen oder sich während des Prozesses aufbauen. Solche Unsymmetrien können zu Differenzen in den Impedanzen und Brennspannungen der Targets führen. Diese Differenzen führen zu unterschiedlicher Leistungszufuhr und zu unterschiedlichen Abnutzungszeiten. Dieser Effekt kann dazu führen, dass das Target, das bereits weiter abgebaut ist, mehr Leistung verbraucht, als andere Targets, und damit noch schneller abbrennt. Am Ende führt dann dieser Effekt dazu, dass ein Target vollständig abgebrannt ist, während andere noch ausreichend Material aufweisen. Dies Verhalten ist höchst unerwünscht, und obwohl dieses Problem seit langem bekannt ist, gab es bislang noch keine Abhilfe.

Aus der DE 43 24 683 A1 ist ein Verfahren zur Anpassung eines Generators bei bipolaren Niederdruck-Glimmprozessen bekannt. Die Wirkzeit für den Glimmprozess wird während der positiven und/oder negativen Halbwelle so gesteuert, dass mindestens für die Zeit eines Teiles einer negativen und/oder positiven Halbwelle der Glimmeinrichtung keine Energie zugeführt wird.

Aus der EP 0 534 068 A2 ist eine Schaltungsanordnung für ein Stromversorgungsgerät für Geräte und Anlagen der Plasma - und Oberflächentechnik bekannt. Die Schaltungsanordnung zeichnet sich dadurch aus, dass zur bipolaren Stromversorgung die positive und negative Ausgangsklemme eines regelbaren Gleichstromnetzteiles mit dem Brückeneingang einer MOS-FET Brückenschaltung verbunden ist, deren Brückenausgang mit einer Stromerfassungsschaltung zur Steuerung der MOS-FETs und mit den Ausgangsklemmen der Last des Plasmageräts verbunden ist.

### Aufgabe

Aufgabe der Erfindung ist es daher, ein Verfahren bereitzustellen, mit dem die Leistungszufuhr in die Verbraucher beeinflusst werden kann und eine Vorrichtung dazu.

### Gegenstand der Erfindung

Die Aufgabe wird erfindungsgemäß durch ein Verfahren mit den Merkmalen des Anspruchs 1 gelöst.

Die Anpassung erfolgt, indem bei einer Abweichung Leistung zwischen der Wechselstromquelle und mindestens einem der Verbraucher zu- oder abgeführt wird. Durch dieses Verfahren wird sichergestellt, dass die Leistungszufuhr ausgehend von einer Messung der zugeführten Ist-Leistungszufuhr erfolgt. Mit dem erfindungsgemäßen Verfahren ist es bei einem Plasmaprozess möglich, die in die Elektroden gelieferte Leistung unabhängig von der Art der Wechselstromquelle so zu regeln, dass sie einer vorgegebenen Leistungszufuhr entspricht. Alternativ erfolgt die Anpassung dadurch, dass die Steuerung der Wechselstromquelle so verändert wird, dass die Ist- Leistungszufuhr gleich der Soll-Leistungszufuhr ist.

Bei einem Plasmaprozess kann je ein Anschluss der Wechselspannungsquelle an mindestens eine Elektrode angeschlossen sein. Damit sind die Elektroden die Verbraucher, in die Leistung zugeführt wird.

Die Wechselstromquelle soll verstanden werden als eine Leistungsquelle, die an ihrem Ausgang eine wechselnde Spannung und einen wechselnden Strom aufweist. Es kann sich dabei um eine Leistungsquelle mit Stromquellen- oder Spannungsquellencharakeristik oder anderen Charakteristika handeln und der Spannungs- und Stromverlauf kann eine beliebige Form aufweisen und auch einen Gleichanteil beinhalten. Insbesondere sollen aber auch solche Wechselstromquellen eingeschlossen sein, die auf Grund einer galvanischen Trennung an ihrem Ausgang selbst nur Wechselanteile und keine Gleichanteile zur Verfügung stellen. Auch bei solchen Wechselstromquellen ohne Gleichanteile kann die Steuerung der Wechselstromquelle genutzt werden, um die Ist-Leistungszufuhr der Soll-Leistungszufuhr anzupassen.

Die vorgegebene Soll-Leistungszufuhr kann dabei symmetrisch oder unsymmetrisch vorgegeben werden. Je nachdem, ob eine symmetrische oder eine unsymmetrische Soll-Leistungszufuhr vorgegeben wird, wird durch das erfindungsgemäße Verfahren die von der Wechselstromquelle gelieferte Leistung so geregelt, dass.die Ist-Leistungszufuhr in die Verbraucher der Soll-Leistungszufuhr entspricht. Um dafür zu sorgen, dass die Targets gleich große Abnutzungszeiten haben, wird man vorteilhafterweise eine symmetrische Soll-Leistungszufuhr vorgeben. Es sind aber auch Prozesse vorstellbar, bei denen es sinnvoll ist, eine unsymmetrische Soll-Leistungszufuhr vorzugeben, zum Beispiel um einer bereits erfolgten ungleichen Abnutzung entgegenzuwirken oder um Targets mit unterschiedlichen Materialien oder Aufbau in gewünschter Weise abzutragen.

In einer besonderen Ausgestaltung des Verfahrens wird die Ist-Leistungszufuhr erfasst, indem leistungsabhängige Größen für jeden Verbraucher bestimmt werden. Dies kann auf die unterschiedlichsten Weisen geschehen. Eine leistungsabhängige Größe könnte beispielsweise die Temperatur an einer Elektrode sein, oder die Strahlung die von dem Plasma an einer Elektrode ausgeht. Üblicherweise werden zur Bestimmung von leistungsabhängigen Größen Strom und Spannung an den Verbrauchern gemessen.

Bei einem Plasmaprozess mit zwei Elektroden, die jeweils an einen Anschluss der Wechselstromquelle angeschlossen sind, entspricht die mittlere effektive Leistung in jede Elektrode im Wesentlichen dem Strom in Richtung der Elektrode multipliziert mit der Spannung, gemessen von der Elektrode gegen Masse.

In einer vorteilhaften Verfahrensvariante liegt die Frequenz der Wechselstromquelle zwischen 1khz und 1MHz insbesondere zwischen 50kHz und bis 500kHz.

Die Aufgabe wird erfindungsgemäß außerdem durch eine Leistungsversorgung mit den Merkmalen des Anspruchs 7 gelöst. Dabei ist mit einschleifbar gemeint, dass das Einstellglied in Serie zur Wechselstromquelle geschaltet wird. Durch das Einfügen des Einstellgliedes in eine Verbindungsleitung zwischen Wechselstromquelle und Verbraucher kann diese Vorrichtung sehr universell genutzt werden und auch in bestehende Anlagen nachgerüstet werden. Mehrere Verbindungsleitungen können in einer mehradrigen Verbindungsleitung zusammengefasst sein.

Ein wesentlicher Vorteil der Erfindung ist die Erfassung der Ist-Leistungszufuhr zu den Verbrauchern, wodurch eine Regelung der Leistungszufuhr ermöglicht wird. Die Verbraucher können jeweils als mindestens eine Elektrode in einem Plasmaprozess ausgebildet sein. Bei einer Wechselstromquelle mit zwei Anschlüssen kann je eine Elektrode mit einem Anschluß der Wechselstromquelle verbunden sein. Es können auch mehrere Elektroden an einem Anschluss angeschlossen sein. Damit kann die Leistungszufuhrregeleinheit die Abnutzungszeiten der einzelnen mit den Elektroden verbundenen Targets beeinflussen.

Vorteilhafterweise weist das Einstellglied eine steuerbare Gleichspannungsquelle auf. Dies stellt eine besonders einfach zu realisierende Möglichkeit dar, die Leistungszufuhr in die Elektroden zu beeinflussen. An der Gleichspannungsquelle kann eine positive und negative Spannung eingestellt werden, je nachdem in welchen Verbraucher Leistung zugeführt werden soll. Es ist jede beliebige Ausgestaltung dieser Gleichspannungsquelle vorstellbar auch zum Beispiel zwei antiparallel zusammengeschaltete Gleichspannungsquellen, die jede für sich nur eine positive Spannung ausgeben können und wechselseitig zugeschaltet werden, je nachdem welche Spannungspolarität erforderlich ist.

In einer anderen Ausführungsform kann das Einstellglied mindestens eine steuerbare ohmsche Last aufweisen. Die Beeinflussung der Leistungszufuhr wird dabei durch Abfuhr von Leistung von mindestens einem Verbraucher erreicht. Wird in einem Plasmaprozess mit je einer an jeden Anschluss der Wechselstromquelle angeschlossenen Elektrode die Leistungszufuhr in die Elektrode durch den Strom in Richtung der Elektrode und die Spannung von Elektrode zu Masse festgelegt, so kann die Steuerung der Leistungsabfuhr durch eine einzige eingeschleifte ohmsche Last erfolgen, indem die ohmsche Last im Takt der Frequenz der Wechselstromquelle immer in die eine Stromrichtung hochohmiger als in die andere Stromrichtung gesteuert wird. Dies erfordert eine aufwendige und präzise Ansteuerung der ohmschen Last. Eine weniger aufwendige Ansteuerung von ohmschen Lasten ist für eine Anordnung notwendig, bei der zwei ohmsche Lasten über antiparallel zusammengeschaltete Dioden eingeschleift werden, so dass jede ohmsche Last einer Stromrichtung zugeordnet ist.

In einer Weiterführung weisen die ohmschen Lasten steuerbare Halbleiter insbesondere sogenannte Insulated-Gate-Bipolar-Transitors (IGBTs) auf. Diese Elemente können bei entsprechender Beschaltung auf sehr einfache Weise ohmsche Lasten erzeugen, die mit der Stellgröße über eine Ansteuerschaltungsvorrichtung gesteuert werden.

In einer anderen Ausführungsform kann das Einstellglied zwei über antiparallel geschaltete Dioden separierte induktiv steuerbare Drosseln aufweisen. Auch diese werden so gesteuert, dass sie Leistung abführen, um die Ist-Leistungszufuhr der Soll-Leistungszufuhr anzupassen.

In einer nochmals anderen Ausführungsform kann das Einstellglied einen Transformator aufweisen, dessen Primärwicklung in eine Verbindungsleitung von Wechselstromquelle zu Verbraucher einschleifbar ist, und an dessen Sekundärwicklung eine Schaltungsvorrichtung vorgesehen ist, die von der Stellgröße einstellbare Halbleiterbauelemente aufweist. Diese werden ebenfalls so gesteuert, dass Leistung abgeführt wird, um die Ist-Leistungszufuhr der Soll-Leistungszufuhr anzupassen.

Weitere beliebige Ausführungsformen für das Einstellglied zum Zuführen und Abführen von Leistung sind denkbar, auch eine Kombination der erwähnten Ausführungsformen, die beispielsweise sowohl Leistung zuführt wie auch abführt.

In einer weiteren Ausführungsform der Erfindung ist die Erfassungsvorrichtung als eine Messvorrichtung für leistungsabhängige Größen ausgebildet. Das kann auf unterschiedliche Weisen erfolgen. Eine mögliche Messvorrichtung besteht aus Messeinrichtungen für die Spannung an jedem Verbraucher, insbesondere die Spannung von Verbraucher zu Masse und einer weiteren Messeinrichtung für den Strom in die Verbraucher und einem Multiplizierglied, das aus der gemessenen Spannung und dem gemessenen Strom die Leistung für jeden Verbraucher ermittelt.
Es gibt weitere Möglichkeiten für die Ermittlung einer leistungsabhängigen Größe, von der nur beispielhaft noch eine Temperaturmesseinrichtung an jedem Verbraucher erwähnt werden soll.

Bei Zusammenlegung der Wechselstromquelle und der Leistungszufuhrregeleinheit in eine Einheit können dieselben Strom- und Spannungsmesseinrichtungen sowohl für die Steuerung der Wechselstromquelle als auch für die Leistungszufuhrregeleinheit genutzt werden.

In einer Ausführungsform weist die Wechselstromquelle einen Ausgangsübertrager auf, an dessen Ausgang eine leistungsmäßig galvanisch von Masse getrennte Wechselspannung anliegt, die selbst nur einen Wechselanteil und keinen Gleichanteil aufweist, und die mit den Verbrauchern über Verbindungsleitungen verbunden ist. Die Anordnung mit dem Ausgangsübertrager hat den Vorteil, dass die Wechselspannungen am Ausgang der Leistungsversorgung durch Veränderung der Wicklungszahl des Ausgangsübertragers auf die Anforderungen der Verbraucher eingestellt werden können. Es können für unterschiedliche Anwendungsbereiche bis auf die Ausgangsübertrager identische Leistungsversorgungen aufgebaut werden. Die Ausgangsübertrager können sehr ähnlich zueinander aufgebaut werden. Mit "leistungsmäßig galvanisch von Masse getrennt" ist gemeint, dass die Masse der Wechselstromquelle und die Wechselspannung keine galvanische Verbindung außerhalb der Plasmakammer aufweisen, über die ein nennenswerter Anteil der Leistung fließt. Eine "leitungsmäßig galvanische Trennung von Masse" liegt im Sinne dieser Erfindung also auch dann vor, wenn eine hochohmige Verbindung von der Wechselspannung am Ausgang der Leistungsversorgung zu Masse, zum Beispiel zur Spannungsmessung oder zur Ableitung von Aufladungen von den Elektroden vorgesehen ist, oder wenn eine leitende Verbindung von den Elektroden zu Masse innerhalb der Plasmakammer besteht. Für solche Anordnungen gab es bislang keine Möglichkeit, die Leistung auf die Elektroden aufzuteilen, die Brennspannungen und damit die Leistungszufuhren an den Elektroden stellten sich von selbst ein und es gab keine Möglichkeit der Einflussnahme. Die Erfindung bietet nun eine Möglichkeit der Regelung der Leistungszufuhr in die Verbraucher auch für solche Leistungsversorgungen.

In einer Weiterbildung weist die Leistungsversorgung an der primärseitigen Seite des Ausgangsübertragers einen Schwingkreis auf, der üblicherweise in der Nähe der Resonanz betrieben wird, einen sogenannten Resonanzkreis . Solche Wechselstromquellen besitzen sehr gute Wirkungsgrade. Primärinduktivitäten von dem Ausgangsübertrager können als Induktivitäten für diesen Resonanzkreis genutzt werden.

In einer Ausbildung der Leistungsversorgung weist diese eine Arc-Managementschaltung auf, die eine weitere auf das Einstellglied wirkende Stellgröße generiert. Plasmaprozesse laufen nicht immer vollkommen kontinuierlich ab. Es kommt durch Unreinheiten, zeitlich und örtlich begrenzte Aufladungen oder andere Instabilitäten in der Kammer in unregelmäßigen Abständen zu Überschlägen im Plasma, sogenannten Arcs. Diese Arcs haben zumeist unerwünschte Folgen, wie etwa rasanten Stromanstieg und Spannungseinbruch. Der Plasmaprozess ist gestört, es kann zu unerwünschten Folgen für Target und Plasmaprozess kommen. Bei Leistungsversorgungen für Plasmaprozesse sind deswegen sogenannte Arc-Managementschaltungen bekannt. Sie sorgen für die Unterbindung von unerwünschter Leistungszufuhr in einem solchen Arc-Fall. In der Regel wird die Stromversorgung nach Erkennen eines solchen Arcs schnellstmöglich oder nach einer definierten Zeit abgeschaltet. Dabei kommt es zum Schutz der Leistungsversorgung, der Targets und der zu beschichtenden Objekte oftmals darauf an, die Leistungszufuhr in den Plasmaprozess so schnell wie möglich zu unterbinden.

Vorteilhafterweise wird die Arc-Managementschaltung mit dem Einstellglied verbunden und die Leistung bei Auftreten eines Arcs immer dann über das Einstellglied abgeführt, wenn die Arc-Managementschaltung eine Leistungszufuhr zu den Elektroden unterbindet. Die von der Arc- Managementschaltung generierte Stellgröße hat den Vorrang vor der durch das Regelglied generierten Stellgröße.

Die Aufgabe wird erfindungsgemäß außerdem durch eine Leistungsversorgung mit einem aus einem Vergleich der mittels einer Erfassungsvorrichtung erfassten Ist-Leistungszufuhr und einer vorgegebenen Soll-Leistungszufuhr eine Stellgröße ermittelnden Regelglied sowie mit einer durch eine Steuereinrichtung angesteuerte Wechselstromquelle gelöst, wobei die Steuereinrichtung aufgrund der von dem Regelglied übermittelten Stellgröße die Wechselstromquelle so ansteuert dass die Eigenschaften des Wechselstroms so verändert werden, dass die Ist-Leistungszufuhr in die Verbraucher gleich der Soll-Leistungszufuhr ist.

Die Wechselstromquelle kann beispielsweise eine Brückenschaltung mit einem nachfolgenden Resonanzkreis sein. Die Brückenschaltung wird versorgt von einem Gleichstrom. Wird die Brückenschaltung symmetrisch angesteuert, so ergeben sich ein symmetrischer Wechselstrom und eine symmetrische Wechselspannung, die beispielsweise über einen Ausgangsübertrager übertragen werden können. Der Ausgangsübertrager kann Teil eines Resonanzkreises sein.

Bei unsymmetrischer Ansteuerung der Brückenschaltung werden die Schaltelemente der Brückenschaltung mit einem unsymmetrischen Tastverhältnis angesteuert. Dadurch kann sich beispielsweise die Dauer der positiven Halbwelle verkürzen und die Dauer der negativen Halbwelle der Wechselspannung verlängern. Wenn die Amplitude der verkürzten Halbwelle entsprechend größer ist als die der verlängerten Halbwelle, ergibt sich ein Signal ohne Gleichanteile, das über den Ausgangsübertrager an den Ausgang der Wechselstromquelle übertragen werden kann. Ein solches unsymmetrisches Signal erzeugt, wie Messungen an Plasmaprozessen belegen, eine unsymmetrische Lastverteilung auf die Verbraucher (Targets). Diese Unsymmetrie der Lastverteilung lässt sich durch eine unsymmetrische Steuerung der Wechselstromquelle steuern. Damit lässt sich die Ist-Leistungszufuhr der Soll-Leistungszufuhr anpassen für symmetrische und unsymmetrische Soll-Leistungszufuhren.

Solche unsymmetrischen Ansteuerungen verursachen große Ströme im Ausgangsübertrager, die bei herkömmlichen Übertragern mit Eisen- oder Ferrit-Kernen zur Sättigung des Kernmaterials führen können, wie beispielsweise in US 6,532,161 beschrieben. Ein Luftübertrager besitzt keinen Eisen- oder Ferritkern und kann demnach auch nicht in Sättigung gehen. Deswegen wird vorteilhafterweise ein Luftübertrager verwendet.

Weitere Merkmale und Vorteile der Erfindung ergeben sich aus der nachfolgenden Beschreibung von Ausführungsbeispielen der Erfindung, anhand der Figuren der Zeichnung, die erfindungswesentliche Einzelheiten zeigen, und aus den Ansprüchen. Die einzelnen Merkmale können je einzeln für sich oder zu mehreren in beliebiger Kombination bei einer Variante der Erfindung verwirklicht sein.

### Zeichnung

### Ausführungsbeispiele der erfindungsgemäßen

Leistungszufuhrregeleinheit sind in der schematischen Zeichnung dargestellt und werden in der nachfolgenden Beschreibung erläutert. Es zeigt:
- **Fig. 1**: Eine Leistungszufuhrregeleinheit mit Wechselstromquelle und Plasmakammer;
- **Fig. 2**: Eine Leistungsversorgung, die eine Wechselstromquelle, eine Leistungszufuhrregeleinheit und eine Arc- Managementschaltung vereint und eine Plasmakammer;
- **Fig. 3**: Eine Wechselstromquelle mit Ausgangsübertrager und Resonanzkreis;
- **Fig. 4**: Ein Einstellglied mit gesteuerten Gleichspannungsquellen;
- **Fig. 5**: Ein Einstellglied mit zwei ohmschen Lasten, die als IGBT ausgebildet sind;
- **Fig. 6**: Ein Einstellglied mit zwei steuerbaren Drosseln;
- **Fig. 7**: Ein Einstellglied mit einem sekundärseitig kurzschließbaren Transformator;
- **Fig. 8**: Ein Einstellglied mit ebenfalls sekundärseitig kurzschließbaren Transformator; und
- **Fig. 9**: eine Leistungsversorgung mit einer ansteuerbaren Wechselstromquelle.

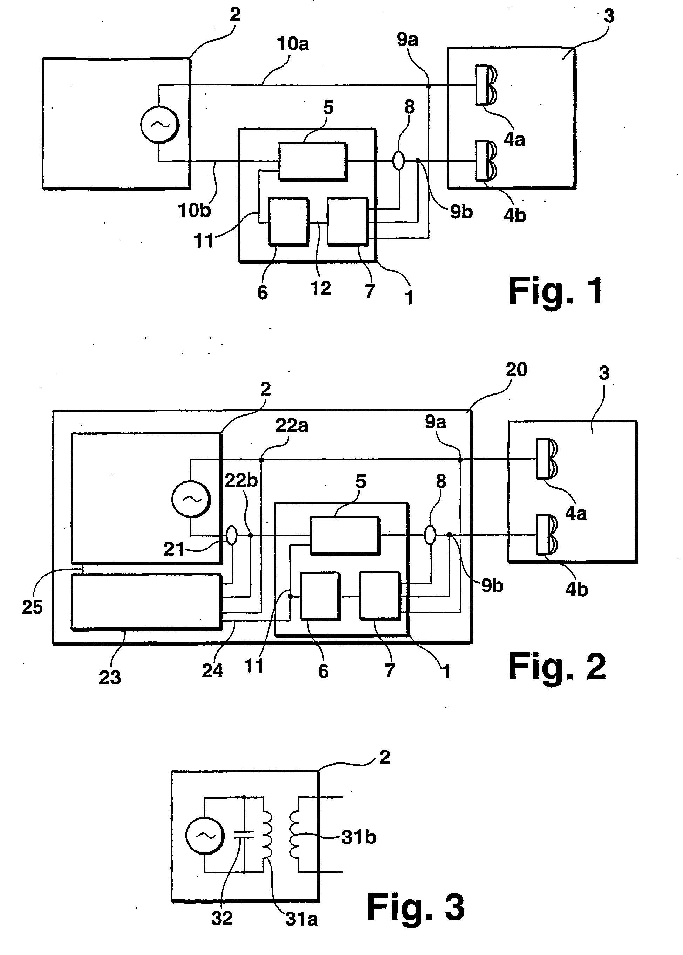

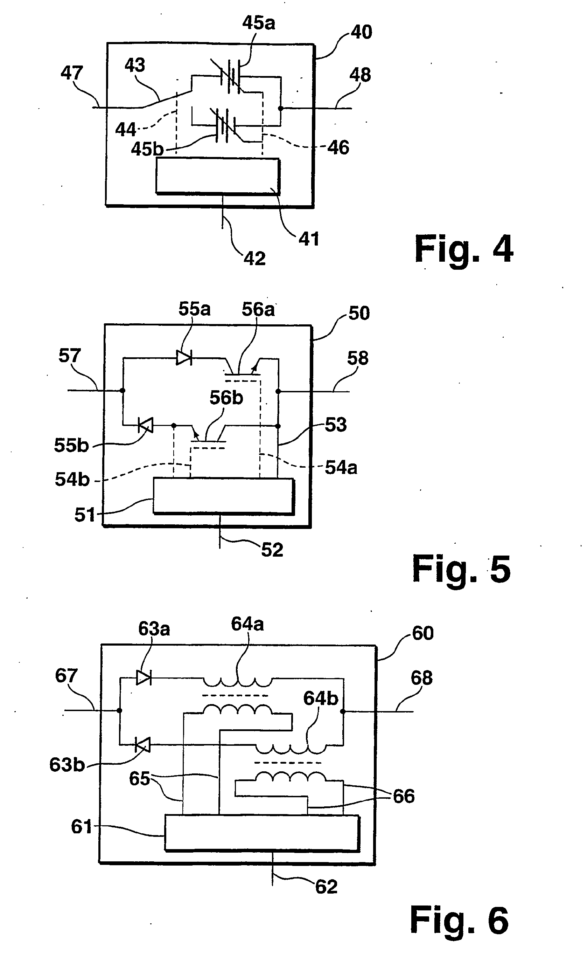

**Fig. 1** zeigt eine schematische Darstellung einer Leistungszufuhrregeleinheit **1** zusammen mit einer Wechselstromquelle **2** und einer Plasmakammer **3.** Die Wechselstromquelle ist über zwei Verbindungsleitungen **10a, 10b** mit den zwei als Elektroden **4a, 4b** ausgebildeten Verbrauchern verbunden, die in der Plasmakammer 3 positioniert sind. Die Leistungszufuhrregeleinheit 1 umfasst die drei Komponenten Einstellglied **5,** Regelglied **6** und Messgrößenerfassungsglied **7.** Das Einstellglied 5 ist in die Verbindungsleitung 10b eingeschleift. Es erhält vom Regelglied 6 über die Verbindung **11** die Stellgröße. An den Knoten **9a, 9b** auf den Verbindungsleitungen 10a, 10b wird die Spannung gemessen und zu je einem Spannungssignal aufgearbeitet. Mit der Messeinrichtung **8** wird der Strom in der Verbindungsleitung 10b gemessen und zu einem Strommesssignal aufgearbeitet. Das Messgrößenerfassungsglied 7, die Messeinrichtung 8 und die Spannungsmessung an den Knoten 9a, 9b stellen eine Erfassungsvorrichtung für die Ist-Leistungszufuhr in die Verbraucher dar. Aus diesen Messsignalen ermittelt das Messgrößenerfassungsglied 7 jeweils ein Leistungssignal, das der effektive Leistung, die den Elektroden 4a und 4b zugeführt wird, entspricht. Im Wesentlichen besteht die Leistung in Elektrode 4a aus der Spannung gemessen an der Elektrode 4a oder am Knoten 9a multipliziert mit dem Strom in Richtung dieser Elektrode. Genauso besteht die Leistung in Elektrode 4b im Wesentlichen aus der Spannung gemessen an der Elektrode 4b oder am Knoten 9b multipliziert mit dem Strom in Richtung dieser Elektrode. Der mit der Messeinrichtung 8 gemessene Strom kann in einen positiven und einen negativen Anteil aufgeteilt werden. Der positive Anteil des Stroms multipliziert mit der am Knoten 9a gemessenen Spannung ergibt die der Elektrode 4a zugeführte effektive Leistung. Der negative Anteil des Stroms multipliziert mit dem am Knoten 9b gemessenen Spannung ergibt die der Elektrode 4b zugeführte effektive Leistung. Demnach berechnet je ein Multiplizierglied aus den Strommessignalanteilen und den Spannungsmessignalen je ein Leistungssignal für jede Elektrode. Aus den beiden Leistungssignalen wird die Ist-Leistungszufuhr in die Elektroden ermittelt. Diese wird über eine Verbindung **12** an das Regelglied 6 übermittelt. Das Regelglied 6 vergleicht die Ist-Leistungszufuhr mit einer internen Soll-Leistungszufuhr. Ist sie symmetrisch, so stellt das Regelglied 6 die Stellgröße so ein, dass beiden Elektroden eine gleich große Leistung zugeführt wird. Das Einstellglied 5 kann für jede Stromrichtung Leistung zuführen oder abführen. Dies wird in den Beschreibungen zu den Fig. 4 bis 8 anhand der dort beschriebenen Ausführungsbeispiele näher erläutert.

**Fig. 2** zeigt eine Leistungsversorgung **20,** die die Wechselstromquelle 2 und die Leistungszufuhrregeleinheit 1 gemäß Fig. 1, sowie eine zusätzliche Arc-Managementschaltung **23** einschließt. Für die gleichen Komponenten und Elemente wurden dieselben Bezugszeichen wie unter Fig. 1 verwendet. In diesem Ausführungsbeispiel ermittelt die Arc-Managementschaltung 23 den Strom über die Messeinrichtung **21** und die Spannung an den Knoten **22a** und **22b.** Auf diese Weise kann die Arc-Managementschaltung 23 einen Arc erkennen. Sie steuert sowohl über die Verbindung **25** die Wechselstromquelle 2 als auch über die Verbindung **24** das Einstellglied 5. Auf diese Weise kann, wenn die Arc-Managementschaltung die Leistungszufuhr in die als Elektroden 4a, 4b ausgebildeten Verbraucher unterbricht, die verbleibende Leistung über das Einstellglied 5 abgeführt werden.

**Fig. 3** zeigt eine Wechselstromquelle 2 aus Fig. 1 und 2 in einer besonderen Ausführungsform. Die Wechselstromquelle weist einen Ausgangsübertrager mit einer Primärwicklung **31a** und einer Sekundärwicklung **31b** und einen Schwingkreiskondensator **32** auf. Die Wechselspannung einer solchen Wechselstromquelle weist an ihren Ausgängen keinen Gleichanteil auf. Die Kapazität 32 und die Primärinduktivität vom Übertrager (31a, 31b) ergeben zusammen einen Schwingkreis, der in der Nähe der Resonanz betrieben wird. Solche Wechselstromquellen weisen besondere Vorteile auf. Mit Hilfe einer Änderung der Sekundärwicklung 31b des Übertragers können die Ausgangsspannungen und Ausgangsströme den Anforderungen der Verbraucher sehr einfach angepasst werden. Für unterschiedliche Verbraucher muss dann nur ein geänderter Übertrager verwendet werden und nicht eine komplett neue Stromversorgung. Der Resonanzkreis sorgt für einen hohen Wirkungsgrad der Stromversorgung.

**Fig. 4 bis 7** zeigen Beispiele des in Fig. 1 gezeigten Einstellglieds 5. Es ist jeweils in die Verbindungsleitung 10b zwischen Wechselstromquelle 2 und Plasmakammer 3 eingeschleift.

In **Fig. 4** hat dieses Einstellglied das Bezugszeichen **40,** es ist an den Anschlüssen **47** und **48** in die Verbindungsleitung 10b eingeschleift. Es erhält über die Verbindung **42** die Stellgröße, die es in einer Ansteuerschaltungsvorrichtung **41** zu einem Ansteuersignal **46** für zwei antiparallel zusammengeschaltete einstellbare Gleichstromversorgungen **45a, 45b** umsetzt. Ein Schalter **43** wird von einem weiteren Ansteuersignal **44,** angesteuert, das ebenfalls von der Ansteuerschaltungsvorrichtung **41** erzeugt wird. Er schaltet jeweils die Gleichstromversorgung 45a oder 45b zu, die die erwünschte Polarität aufweist. Mit dieser Anordnung wird eine Leistung zugeführt. Anstatt der zwei umschaltbaren Gleichstromversorgungen kann auch eine Gleichstromversorgung mit einem Umpoler vorgesehen werden oder eine Gleichstromversorgung mit zwei Ausgangspolaritäten.

In **Fig. 5** hat das Einstellglied das Bezugszeichen **50,** es ist an den Anschlüssen **57** und **58** in die Verbindungsleitung 10b eingeschleift. Es erhält über die Verbindung **52** die Stellgröße, die es in einer Ansteuerschaltungsvorrichtung **51** zu Ansteuersignalen **54a, 54b** für zwei IGBTs **56a, 56b** umsetzt. Diese sind mit antiparallel zusammengeschalteten Dioden **55a** und 55b in der Weise verschaltet, dass immer ein IGBT 56a, 56b den Strom für eine Richtung führt. Die IGBTs 56a, 56b werden so angesteuert, dass sie ohmsche Lasten in Durchlassrichtung darstellen. Auf diese Weise kann jede Stromrichtung unabhängig gesteuert werden. Da die Leistung in jeweils eine der beiden Elektroden direkt vom Strom in Richtung dieser Elektrode abhängt, kann die Leistung in jede Elektrode unabhängig gesteuert werden.

In **Fig. 6** hat das Einstellglied das Bezugszeichen **60,** es ist an den Anschlüssen **67** und **68** in die Verbindungsleitung 10b eingeschleift. Es erhält über die Verbindung **62** die Stellgröße, die es in einer Ansteuerschaltungsvorrichtung **61** zu Ansteuerstromkreisen **65, 66** für zwei induktiv steuerbare Drosseln **64a, 64b** umsetzt. Diese sind mit antiparallel zusammengeschalteten Dioden **63a** und **63b** in der Weise verschaltet, dass immer eine Drossel den Strom für eine Richtung führt. Auf diese Weise fließt ein hoher Gleichstromanteil durch die Drosseln. Diese sind nun so ausgelegt, dass sie mit diesem Gleichstromanteil in der Sättigung arbeiten und nur einen geringen Widerstand für den durchfließenden Strom darstellen. Die Drosseln 64a, 64b sind über die Stromkreise 65 und 66 so induktiv vormagnetisierbar, dass sie jede für sich steuerbar aus der Sättigung genommen werden können und so einen höheren Widerstand für den durchlaufenden Strom darstellen. Damit kann wieder für jede Stromrichtung getrennt die Leistungszufuhr eingestellt werden.

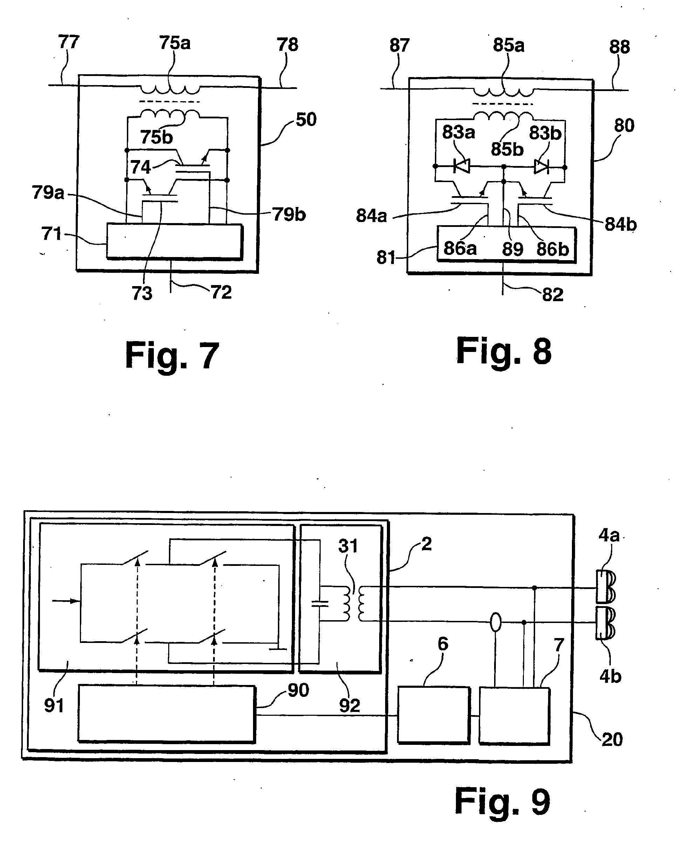

In **Fig. 7** hat das Einstellglied das Bezugszeichen **70,** es ist an den Anschlüssen **77** und **78** in die Verbindungsleitung 10b eingeschleift. Es erhält über die Verbindung **72** die Stellgröße, die es in einer Ansteuerschaltungsvorrichtung **71** zu Ansteuersignalen **79a, 79b** für zwei antiparallel geschaltete IGBTs **73, 74** umsetzt. Ein Transformator mit einer Primärwicklung **75a** ist zwischen die Anschlüsse 77 und 78 geschaltet. Die Sekundärwicklung **75b** wird von den IGBTs 73, 74 im Normalfall kurzgeschlossen. Je nachdem, in welche Stromrichtung die Leistung abgeführt werden soll, wird entweder der IGBT 73 über das Ansteuersignal 79a oder der IGBT 74 über das Ansteuersignal 79b in einen hochohmigen Zustand gebracht. Damit kann wieder für jede Stromrichtung getrennt die Leistungszufuhr eingestellt werden.

In **Fig. 8** hat das Einstellglied das Bezugszeichen **80,** es ist an den Anschlüssen **87** und **88** in die Verbindungsleitung 10b eingeschleift. Es erhält über die Verbindung **82** die Stellgröße, die es in einer Ansteuerschaltungsvorrichtung **81** zu Ansteuersignalen **86a, 86b** für zwei an einem Netzknoten **89** zusammengeschaltete IGBTs **84a, 84b** umsetzt. Ein Transformator mit einer Primärwicklung **85a** ist zwischen die Anschlüsse 87 und **88** geschaltet. Die Sekundärwicklung **85b** wird ähnlich wie in Fig.7 im Normalfall kurzgeschlossen. Diesmal führt der Strom aber noch zusätzlich über die Dioden **83a** und **83b,** die parsitäre Dioden in den IGBTs 84a, 84b oder externe Dioden sein können. Durch die Ansteuersignale 86a, 86b können die IGBTs 84a, 84b einzeln und unabhängig voneinander in einen hochohmigen Zustand gebracht werden. Damit kann wieder für jede Stromrichtung getrennt die Leistungszufuhr eingestellt werden.

**Fig. 9** zeigt eine Leistungsversorgung 20, die die Wechselstromquelle 2, der ein Gleichstrom zugeführt ist, ein Regelglied 6 und ein Messgrößenerfassungsglied 7 einschließt. Für die gleichen Komponenten und Elemente wurden dieselben Bezugszeichen wie unter Fig. 1 bis 3 verwendet.
Das Regelglied 6 ist verbunden mit einer Steuerungseinrichtung **90.** Die Steuerungseinrichtung 90 steuert die Brückenschaltung **91** an. An die Brückenschaltung 91 ist ein Resonanzkreis **92** angeschlossen, wobei der Ausgangsübertrager 31 ein Teil des Resonanzkreises 92 darstellt. Die im Messgrößenerfassungsglied 7, das Teil einer Erfassungsvorrichtung ist, erfassten leistungsabhängigen Ist-Größen werden im Regelglied 6 mit den Sollgrößen verglichen. Das Regelglied 6 ermittelt daraus eine Stellgröße, die an die Steuerungseinrichtung 90 weiter gegeben wird. Diese steuert die Ein- und Ausschaltdauern, d.h. das Tastverhältnis, der einzelnen Schalter der Brückenschaltung 91 daraufhin so, dass die erfassten Ist-Leistungsgrößen gleich den vorgegebenen Soll-Größen sind. Der Resonanzkreis 92 formt die Ausgangsspannung der Brückenschaltung 91 zu einem Signal, das ähnlich einer Sinusform ist. Dieses Signal kann unsymmetrisch sein, über den Übertrager 31 werden aber keine Gleichanteile übertragen.

Trotzdem kann, die Leistungszufuhr in die Verbraucher 4a, 4b unterschiedlich sein und durch die Ansteuerung der Schalter der Brückenschaltung 91 mit einem bestimmten, von der Steuerungseinrichtung 90 vorgegebenen Tastverhältnis, eingestellt werden. Das Tastverhältnis kann für jeden Schalter oder paarweise unterschiedlich und unsymmetrisch sein, d.h. die Ein- und Ausschaltzeiten können unterschiedlich lang sein. Aus diese Weise kann die Ist-Leistungszufuhr in die Verbraucher der vorgegebenen Soll-Leistungszufuhr angepasst werden.

## Patentansprüche

1. Verfahren zur Regelung der Leistungszufuhr der von einer Wechselstromquelle (2) gelieferten Leistung auf mindestens zwei Verbraucher, insbesondere auf Verbraucher in einem Plasmaprozess, wobei die Ist-Leistungszufuhr auf die Verbraucher erfasst wird, mit einer vorgegebenen Soll-Leistungszufuhr verglichen wird, und bei einer Abweichung die Leistungszufuhr für jeden Verbraucher angepasst wird, **dadurch gekennzeichnet, dass** die Wechselstromquelle (2) gesteuert wird, indem eine in der Wechselstromquelle (2) enthaltene Brückenschaltung (91) angesteuert wird.

2. Verfahren nach Anspruch 1, **dadurch gekennzeichnet, dass** die Anpassung der Leistungszufuhr für jeden Verbraucher durch Zufuhr und/oder Abfuhr von Leistung zwischen der Wechselstromquelle (2) und mindestens einem der Verbraucher erfolgt.

3. Verfahren nach Anspruch 1 oder 2 **dadurch gekennzeichnet, dass** eine symmetrische oder unsymmetrische Soll-Leistungszufuhr vorgegeben wird.

4. Verfahren nach einem der vorhergehenden Ansprüche, **dadurch gekennzeichnet, dass** die Ist-Leistungszufuhr erfasst wird, indem leistungsabhängige Größen für jeden Verbraucher bestimmt werden.

5. Verfahren nach einem der Ansprüche 1 bis 4 **dadurch gekennzeichnet, dass** von der Wechselstromquelle ein Wechselstrom im Frequenzbereich zwischen 1kHz und 1MHz insbesondere zwischen 50kHz und 500kHz erzeugt wird.

6. Verfahren nach Anspruch 5, **dadurch gekennzeichnet, dass** die Schalter der Brückenschaltung (91) mit einem unsymmetrischen Tastverhältnis angesteuert werden.

7. Leistungsversorgung (20) umfassend eine Wechselstromquelle (2) und eine Leistungszufuhrregeleinheit (1) zur Regelung der von einer Wechselstromquelle (2) in mindestens zwei Verbraucher (Elektroden 4a, 4b), insbesondere Verbraucher in einem Plasmaprozess, gelieferten Leistung, welche ein aus einem Vergleich der mittels einer Erfassungsvorrichtung erfassten Ist-Leistungszufuhr und einer vorgegebenen Soll-Leistungszufuhr eine Stellgröße ermittelndes Regelglied (6) aufweist, und welche ein zwischen die Wechselstromquelle (2) und mindestens einen Verbraucher einschleifbares aufgrund der Stellgröße die Leistungszufuhr einstellendes Einstellglied (5, 40, 50, 60, 70, 80) aufweist; **dadurch gekennzeichnet, dass** die Wechselstromquelle (2) eine Brückenschaltung (91) aufweist.

8. Leistungsversorgung (20) nach Anspruch 7 **dadurch gekennzeichnet, dass** die Wechselstromquelle (2) einen Ausgangsübertrager (31a, 31b) aufweist, an dessen Ausgang eine von Masse leistungsmäßig galvanisch getrennte Wechselspannung anliegt, die nur aus einem Wechselanteil besteht.

9. Leistungsversorgung (20) nach Anspruch 8 **dadurch gekennzeichnet, dass** der Ausgangsübertrager (31a, 31b) primärseitig einen Resonanzkreis (31a, 32) aufweist.

10. Leistungsversorgung (20) nach einem der Ansprüche 7 bis 9 **dadurch gekennzeichnet, dass** die Leistungsversorgung eine Arc-Managementschaltung (23) aufweist, die eine weitere auf das Einstellglied (5, 40, 50, 60, 70, 80) wirkende Stellgröße generiert.

11. Leistungsversorgung (20) nach einem der Ansprüche 7 bis 10 **dadurch gekennzeichnet, dass** das Einstellglied (40) mindestens eine steuerbare Gleichspannungsquelle (45a, 45b) aufweist.

12. Leistungsversorgung (20) nach einem der Ansprüche 7 bis 10, **dadurch gekennzeichnet, dass** das Einstellglied (50) mindestens eine steuerbare ohmsche Last aufweist.

13. Leistungsversorgung (20) nach Anspruch 12 **dadurch gekennzeichnet, dass** das Einstellglied (50) zwei über antiparallel geschaltete Dioden (55a, 55b) separierte steuerbare ohmsche Lasten aufweist.

14. Leistungsversorgung (20) nach Anspruch 12 oder 13 **dadurch gekennzeichnet, dass** die ohmschen Lasten steuerbare Halbleiter insbesondere IGBTs (56a, 56b) aufweisen.

15. Leistungsversorgung (20) nach einem der Ansprüche 7 bis 14 **dadurch gekennzeichnet, dass** das Einstellglied (60) zwei über antiparallel geschaltete Dioden (63a, 63b) separierte induktiv steuerbare Drosseln (64a, 64b) aufweist.

16. Leistungsversorgung (20) nach einem der Ansprüche 7 bis 15 **dadurch gekennzeichnet, dass** das Einstellglied (70, 80) einen Transformator aufweist, dessen Primärwicklung (75a, 85a) in eine Verbindungsleitung (10b) zwischen Wechselstromquelle (2) und Verbraucher (Elektrode 4b) einschleifbar ist, an dessen Sekundärwicklung (75b, 85b) eine Schaltungsvorrichtung vorgesehen ist, die von Ansteuersignalen (79a, 79b, 86a, 86b) gesteuert ist, die ihrerseits von einer Ansteuerschaltungsvorrichtung (71, 81) aus der Stellgröße generiert sind.

17. Leistungsversorgung (20) nach einem der Ansprüche 7 bis 16 **dadurch gekennzeichnet, dass** die Erfassungsvorrichtung als eine Messvorrichtung für leistungsabhängige Größen ausgebildet ist.

18. Leistungsversorgung (20), für mindestens zwei Verbraucher, mit einem aus einem Vergleich der mittels einer Erfassungsvorrichtung erfassten Ist-Leistungszufuhr und einer vorgegebenen Soll-Leistungszufuhr in die Verbraucher eine Stellgröße ermittelnden Regelglied (6) sowie mit einer durch eine Steuereinrichtung (90) angesteuerte Wechselstromquelle (2), wobei die Steuereinrichtung (90) aufgrund der von dem Regelglied (6) übermittelten Stellgröße die Wechselstromquelle (2) so ansteuert dass die Eigenschaften des Wechselstroms so verändert werden, dass die Ist-Leistungszufuhr in die Verbraucher (4a, 4b) gleich der Soll-Leistungszufuhr ist; **dadurch gekennzeichnet, dass** die Wechselstromquelle (2) eine Brückenschaltung (91) aufweist.

19. Leistungsversorgung (20) nach Anspruch 18, **dadurch gekennzeichnet, dass** die Wechselstromquelle (2) einen der Brückenschaltung (91) nachgeschalteten Resonanzkreis (92) aufweist.

20. Leistungsversorgung (20) nach Anspruch 18 oder 19, **dadurch gekennzeichnet, dass** die Wechselstromquelle (2) zusätzlich eine Ausgangsübertrager (31) aufweist.

21. Leistungsversorgung (20) nach Anspruch 20, **dadurch gekennzeichnet, dass** der Ausgangsübertrager (31) ein Luftübertrager ist.

## Claims

1. Method for regulating the supply of power, delivered from an alternating current source (2), to at least two loads, especially to loads in a plasma process, the actual power supply to the loads being detected, compared with a predetermined nominal power supply and, if there is a difference, the power supply being adjusted for each load, **characterised in that** the alternating current source (2) is controlled by driving a bridge circuit (91) contained in the alternating current source (2).

2. Method according to claim 1, **characterised in that** the adjustment of the power supply for each load is effected by supplying and/or removing power between the alternating current source (2) and at least one of the loads.

3. Method according to claim 1 or 2, **characterised in that** a symmetrical or asymmetrical nominal power supply is predetermined.

4. Method according to any one of the preceding claims, **characterised in that** the actual power supply is detected by determining power-dependent variables for each load.

5. Method according to any one of claims 1 to 4, **characterised in that** an alternating current in the frequency range of from 1kHz to 1MHz, especially from 50kHz to 500kHz, is generated by the alternating current source.

6. Method according to claim 5, **characterised in that** the switches of the bridge circuit (91) are driven with an asymmetrical mark-to-space ratio.

7. Power supply (20) comprising an alternating current source (2) and a power supply control unit (1) for regulating the power delivered from an alternating current source (2) to at least two loads (electrodes 4a, 4b), especially loads in a plasma process, which power supply control unit (1) has a control member (6) which determines a controlling variable from a comparison of the actual power supply detected by means of a detecting device and a predetermined nominal power supply, and which power supply control unit (1) has an adjusting member (5, 40, 50, 60, 70, 80) which can be connected between the alternating current source (2) and at least one load and which adjusts the power supply on the basis of the controlling variable, **characterised in that** the alternating current source (2) has a bridge circuit (91).

8. Power supply (20) according to claim 7, **characterised in that** the alternating current source (2) has an output transformer (31a, 31b) at the output of which there is present an alternating voltage which is galvanically isolated from earth in terms of power and which comprises only one alternating portion.

9. Power supply (20) according to claim 8, **characterised in that** the output transformer (31a, 31b) has a resonant circuit (31a, 32) on the primary side.

10. Power supply (20) according to any one of claims 7 to 9, **characterised in that** the power supply has an arc management circuit (23) which generates a further controlling variable acting on the adjusting member (5, 40, 50, 60, 70, 80) .

11. Power supply (20) according to any one of claims 7 to 10, **characterised in that** the adjusting member (40) has at least one controllable direct voltage source (45a,-45b).

12. Power supply (20) according to any one of claims 7 to 10, **characterised in that** the adjusting member (50) has at least one controllable ohmic load.

13. Power supply (20) according to claim 12, **characterised in that** the adjusting member (50) has two controllable ohmic loads separated by means of diodes (55a, 55b) connected in a back-to-back manner.

14. Power supply (20) according to claim 12 or 13, **characterised in that** the ohmic loads have controllable semi-conductors, especially IGBTs (56a, 56b).

15. Power supply (20) according to any one of claims 7 to 14, **characterised in that** the adjusting member (60) has two inductively controllable impedances (64a, 64b) separated by means of diodes (63a, 63b) connected in a back-to-back manner.

16. Power supply (20) according to any one of claims 7 to 15, **characterised in that** the adjusting member (70, 80) has a transformer, the primary winding (75a, 85a) of which can be connected into a connecting line (10b) between the alternating current source (2) and the load (electrode 4b) and at the secondary winding (75b, 85b) of which there is provided a switching device which is controlled by driving signals (79a, 79b, 86a, 86b) which are for their part generated by a driving circuit device (71, 81) from the controlling variable.

17. Power supply (20) according to any one of claims 7 to 16, **characterised in that** the detecting device is in the form of a measuring device for power-dependent variables.

18. Power supply (20), for at least two loads, having a control member (6) determining a controlling variable from a comparison of the actual power supply, detected by means of a detecting device, and a predetermined nominal power supply to the loads, and having an alternating current source (2) driven by a control device (90), the control device (90) driving the alternating current source (2) on the basis of the controlling variable transmitted by the control member (6), in such a manner that the properties of the alternating current are so altered that the actual power supply to the loads (4a, 4b) is the same as the nominal power supply, **characterised in that** the alternating current source (2) has a bridge circuit (91).

19. Power supply (20) according to claim 18, **characterised in that** the alternating current source (2) has a resonant circuit (92) connected downstream of the bridge circuit (91) .

20. Power supply (20) according to claim 18 or 19, **characterised in that** the alternating current source (2) additionally has an output transformer (31).

21. Power supply (20) according to claim 20, **characterised in that** the output transformer (31) is an air transformer.

## Revendications

1. Procédé de régulation de l'amenée de puissance de la puissance fournie par une source de courant alternatif (2) à au moins deux consommateurs, en particulier à des consommateurs dans un processus de traitement au plasma, dans lequel l'amenée de puissance réelle aux consommateurs est saisie, comparée avec une amenée de puissance nominale prédéfinie, et, en cas de différence, l'amenée de puissance à chaque consommateur est adaptée, **caractérisé en ce que** la source de courant alternatif (2) est commandée en commandant un circuit en pont (91) contenu dans la source de courant alternatif (2).

2. Procédé selon la revendication 1, **caractérisé en ce que** l'adaptation de l'amenée de puissance à chaque consommateur est réalisée par amenée et/ou dissipation de puissance entre la source de courant alternatif (2) et au moins un des consommateurs.

3. Procédé selon la revendication 1 ou 2, **caractérisé en ce qu'**une amenée de puissance nominale symétrique ou asymétrique est prédéfinie.

4. Procédé selon l'une des revendications précédentes, **caractérisé en ce que** l'amenée de puissance réelle est saisie en déterminant des grandeurs dépendantes de la puissance pour chaque consommateur.

5. Procédé selon l'une des revendications 1 à 4, **caractérisé en ce que** la source de courant alternatif génère un courant alternatif dans la gamme de fréquences comprise entre 1 kHz et 1 MHz, en particulier entre 50 kHz et 500 kHz.

6. Procédé selon la revendication 5, **caractérisé en ce que** les commutateurs du circuit en pont (91) sont commandés par un rapport cyclique asymétrique.

7. Alimentation en puissance (20) comprenant une source de courant alternatif (2) et une unité de régulation d'amenée de puissance (1) pour réguler la puissance délivrée par une source de courant alternatif (2) à au moins deux consommateurs (électrodes 4a, 4b), en particulier des consommateurs dans un processus de traitement au plasma, laquelle présente un organe de régulation (6) qui détermine une grandeur réglante à partir d'une comparaison de l'amenée de puissance réelle saisie avec un dispositif de saisie et d'une amenée de puissance nominale prédéfinie, et laquelle présente un organe de réglage (5, 40, 50, 60, 70, 80) qui peut être connecté entre la source de courant alternatif (2) et au moins un consommateur et qui règle l'amenée de puissance sur la base de la grandeur réglante, **caractérisée en ce que** la source de courant alternatif (2) présente un circuit en pont (91).

8. Alimentation en puissance (20) selon la revendication 7, **caractérisée en ce que** la source de courant alternatif (2) présente un transformateur de sortie (31a, 31b) à la sortie duquel est présente une tension alternative isolée électriquement de la masse en ce qui concerne la puissance, qui se compose uniquement d'une composante alternative.

9. Alimentation en puissance (20) selon la revendication 8, **caractérisée en ce que** le transformateur de sortie (31a, 31b) présente un circuit résonant (31a, 32) côté primaire.

10. Alimentation en puissance (20) selon l'une des revendications 7 à 9, **caractérisée en ce que** l'alimentation en puissance présente un circuit de gestion des arcs électriques (23) qui génère une autre grandeur réglante agissant sur l'organe de réglage (5, 40, 50, 60, 70, 80).

11. Alimentation en puissance (20) selon l'une des revendications 7 à 10, **caractérisée en ce que** l'organe de réglage (40) présente au moins une source de tension continue (45a, 45b) pouvant être commandée.

12. Alimentation en puissance (20) selon l'une des revendications 7 à 10, **caractérisée en ce que** l'organe de réglage (50) présente au moins une charge ohmique pouvant être commandée.

13. Alimentation en puissance (20) selon la revendication 12, **caractérisée en ce que** l'organe de réglage (50) présente deux charges ohmiques pouvant être commandées séparées par des diodes en montage antiparallèle (55a, 55b).

14. Alimentation en puissance (20) selon la revendication 12 ou 13 **caractérisée en ce que** les charges ohmiques présentent des semi-conducteurs pouvant être commandés, en particulier des IGBT (56a, 56b).

15. Alimentation en puissance (20) selon l'une des revendications 7 à 14, **caractérisée en ce que** l'organe de réglage (60) présente deux bobines de self pouvant être commandées par induction (64a, 64b) séparées par des diodes en montage antiparallèle (63a, 63b).

16. Alimentation en puissance (20) selon l'une des revendications 7 à 15, **caractérisée en ce que** l'organe de réglage (70, 80) présente un transformateur dont l'enroulement primaire (75a, 85a) peut être connecté dans une ligne de connexion (lOb) entre la source de courant alternatif (2) et un consommateur (électrode 4b), à l'enroulement secondaire duquel (75b, 85b) est prévu un circuit qui est commandé par des signaux de commande (79a, 79b, 86a, 86b) qui sont eux-mêmes générés par un circuit de commande (71, 81) à partir de la grandeur réglante.

17. Alimentation en puissance (20) selon l'une des revendications 7 à 16, **caractérisée en ce que** le dispositif de saisie est réalisé sous la forme d'un dispositif de mesure de grandeurs dépendantes de la puissance.

18. Alimentation en puissance (20), pour au moins deux consommateurs, avec un organe de régulation (6) qui détermine une grandeur réglante à partir d'une comparaison de l'amenée de puissance réelle saisie avec un dispositif de saisie et d'une amenée de puissance nominale prédéfinie aux consommateurs ainsi qu'avec une source de courant alternatif (2) commandée par un dispositif de commande (90), le dispositif de commande (90) commandant la source de courant alternatif (2) sur la base de la grandeur réglante déterminée par l'organe de régulation (6) de manière que les propriétés du courant alternatif soient modifiées de façon que l'amenée de puissance réelle aux consommateurs (4a, 4b) soit égale à l'amenée de puissance nominale, **caractérisée en ce que** la source de courant alternatif (2) présente un circuit en pont (91).

19. Alimentation en puissance (20) selon la revendication 18, **caractérisé en ce que** la source de courant alternatif (2) présente un circuit résonant (92) placé en aval du circuit en pont (91).

20. Alimentation en puissance (20) selon la revendication 18 ou 19, **caractérisée en ce** la source de courant alternatif (2) présente en plus un transformateur de sortie (31).

21. Alimentation en puissance (20) selon la revendication 20, **caractérisée en ce que** le transformateur de sortie (31) est un transformateur à air.
